# EUROPEAN PATENT SPECIFICATION

(11) **EP 2 697 841 B1**
(45) Date of publication and mention of the grant of the patent: **04.09.2019**
(21) Application number: 12718457.0
(22) Date of filing: 23.03.2012
(51) Int. Cl.: H01L 51/52, H05K 1/18, H05K 1/11, F21Y 105/00, F21Y 115/15

(54) **LOW TEMPERATURE CONTACT STRUCTURE FOR FLEXIBLE SOLID STATE DEVICE**
NIEDRIGTEMPERATURKONTAKTSTRUKTUR FÜR FLEXIBLE FESTKÖRPERVORRICHTUNG
STRUCTURE DE CONTACT À BASSE TEMPÉRATURE POUR DISPOSITIF SEMI-CONDUCTEUR FLEXIBLE

(30) Priority: 11.04.2011 US 201113083908
(43) Date of publication of application: 19.02.2014
(73) Proprietor: BOE Technology Group Co., Ltd., Chaoyang District Beijing (CN)
(72) Inventor: KOSTKA, James, Michael, Cleveland, OH 44112 (US); AURONGZEB, Deeder, Cleveland, OH 44112 (US); ROBERTS, Bruce, Richard, Cleveland, OH 44112 (US); BRNADA, Josip, Cleveland, OH 44112 (US)
(74) Representative: Klunker IP Patentanwälte PartG mbB
(86) International application number: PCT/US2012/030242
(87) International publication number: WO 2012/141869

(56) References cited:
- JP-A- 2003 051 385
- US-A1- 2004 016 568
- US-A1- 2009 160 321

## Description

### BACKGROUND

The present invention relates to a light source and particularly a light source connection and a method for providing the same. More particularly, the disclosure relates to a light emitting device such as an organic light emitting diode panel and connection, as well as to low temperature materials and methods suitable for providing electrical connection to such a panel.

Organic light emitting diode (OLED) devices are generally known in the art. An OLED device typically includes one or more organic light emitting layer(s) disposed between electrodes. For example, a cathode, organic layer, and a light-transmissive anode formed on a substrate emit light when current is applied across the cathode and anode. As a result of the electric current, electrons are injected into the organic layer from the cathode and holes may be injected into the organic layer from the anode. The electrons and holes generally travel through the organic layer until they recombine at a luminescent center, typically an organic molecule or polymer. The recombination process results in the emission of a light photon usually in the ultraviolet or visible region of the electromagnetic spectrum.

The layers of an OLED are typically arranged so that the organic layers are disposed between the cathode and anode layers. As photons of light are generated and emitted, the photons move through the organic layer. Those that move toward the cathode, which generally comprises a metal, may be reflected back into the organic layer. Those photons that move through the organic layer to the light-transmissive anode, and finally to the substrate, however, may be emitted from the OLED in the form of light energy. Some cathode materials may be light transmissive, and in some embodiments light may be emitted from the cathode layer, and therefore from the OLED device in a multi-directional manner. Thus, the OLED device has at least a cathode, organic, and anode layers. Of course, additional, optional layers may or may not be included in the light source structure.

Cathodes generally comprise a material having a low work function such that a relatively small voltage causes the emission of electrons. Commonly used materials include metals, such as gold, gallium, indium, manganese, calcium, tin, lead, aluminum, silver, magnesium, lithium, strontium, barium, zinc, zirconium, samarium, europium, and mixtures or alloys of any two or more thereof. On the other hand, the anode layer is generally comprised of a material having a high work function value, and these materials are known for use in the anode layer because they are generally light transmissive. Suitable materials include, but are not limited to, transparent conductive oxides such as indium tin oxide (ITO), aluminum doped zinc oxide (AZO), fluorine doped tin oxide (FTO), indium doped zinc oxide, magnesium indium oxide, and nickel tungsten oxide; metals such as gold, aluminum, and nickel; conductive polymers such as poly(3,4-ethylenedioxythiophene) poly(styrenesulfonate) (PEDOT:PSS); and mixtures and combinations or alloys of any two or more thereof.

Preferably, these light emitting or OLED devices are generally flexible, i.e., are capable of being bent into a shape having a radius of curvature of less than about 10cm. These light emitting devices are also preferably large-area, which means they have a dimension of an area greater than or equal to about 10cm², and in some instances are coupled together to form a generally flexible, generally planar OLED panel comprised of one or more OLED devices, which has a large surface area of light emission. Preferably, the panel is hermetically sealed since moisture and oxygen have an adverse impact on the OLED device.

The flexible nature of the OLED and the temperature tolerance level of the OLED panel combine to make providing a reliable electrical connection difficult. One concern relates to the material used to create the connection, which must be ductile, exhibit a suitable Young's modulus, and have an appropriate coefficient of thermal expansion with regard to a device that operates at temperatures below about 100°C, e.g. below about 80°C. Another concern arises with regard to the material used in the area where the electrical connection is made. While it is known to use silver epoxy or double-sided conductive tape in the area of the connection, both suffer from problems due to early delamination and poor electrical properties, thus shortening the useful life of the device. Structural and electrical deficiencies are, for example, seen in the double-sided conductive tape. In addition to the physical limitations of known materials, as just set forth, such materials, for example conductive epoxies, may eventually provide an acceptable connection but must be processed for extended periods of time, generally more than 4 hours, e.g. more than 10 hours, e.g. up to about 24 hours. This long manufacturing time is the result of the higher temperatures needed in order to render an acceptable connection, which is limited by the temperature parameters of the OLED, which are much lower than the higher temperatures at which such materials are generally processed. Therefore, it takes a longer period of time at a lower temperature to render a connection that is acceptable, but not necessarily up to the desired standard.

What is lacking in the industry is a mechanism for providing a long-lasting, yet flexible, connection that exhibits good electrical properties and is quickly processed even at the lower temperatures tolerated by the OLED panel. It is desired, therefore, that an efficient, less time-consuming, low temperature method, as well as suitable materials for use with the method, be provided for establishing an electrical connection with the light emitting panel of an OLED device, and also that the electrical connection maintain flexibility, be easily and accurately positioned and processed, establish good electrical continuity, and allow the device to maintain a thin profile.

JP 2003/051385 A concerns an electric connection without generating a great amount of heat in electrically connecting an organic electroluminescent element and a wiring board. Accordingly, an electrode terminal part and a conducting part are electrically connected by positioning the electrode terminal part for conducting the organic electroluminescence element and the conducting part of a through hole shape provided on the wiring board, arranging a solder material in the through hole shaped conducting part, and irradiating a laser light to the solder material and melting, wherein, in advance of the electrical connection, treatment for improving absorption of the laser light is applied at least to the solder material.

### SUMMARY

It is an object of the present invention to provide a lighting assembly and an method of establishing a path for an electrical connection in a lighting assembly.

The object is achieved by the features of the respective independent claims. Further embodiments are defined in the respective dependent claims.

A lighting assembly includes a light source having a first generally planar, light source including a perimeter edge. A backsheet is disposed in substantially parallel relation with the light source, and includes at least one electrical feedthrough region extending through the backsheet. In addition, each feedthrough region is substantially covered by a contact patch disposed in substantially planar relation between the backsheet and the light source. A generally planar, connector cable extends over the backsheet from a perimeter thereof and has connector pad(s) positioned thereon to associate with each feedthrough to the light source through the contact patch. A low temperature solder material is disposed between each connector pad and contact patch for establishing electrical connection with the light source, wherein one or more of the light source, connector cable, backsheet, or any portion thereof is constructed of one or more plastics.

In one embodiment, the front barrier sheet is adhesively sealed to the backsheet, thus hermetically encapsulating the light source within the lighting assembly.

In one embodiment, the light source is an OLED, and the connector cable is flexible.

The backsheet may include spaced apart, plural electrical feed-through regions, and consequently the connector cable includes spaced apart, plural electrically conductive pads for establishing electrical connection with the discrete light source portions of the panel. Each of the electrically conductive pads preferably includes an opening that aids in application of the low temperature solder for establishing electrical connection with the light source.

The backsheet includes a metallic patch that covers the feed-through region, providing an electrical pathway to the light source while maintaining the hermetic nature of the panel. This patch material in the area of the feed-through region(s) must also maintain the flexible nature of the device while providing a surface for a reliable and durable electrical connection. This material, which may for example be silver, copper, tin, nickel, gold or a combination thereof, must be compatible with the adhesive material within the hermetic package to prevent delamination and consequent failure due to oxygen and water vapor ingress, and it must also have properties that make it amenable to low temperature soldering techniques, i.e., it must have a high bond strength to the low temperature solder, exhibit low interface resistance, and have good oxidation resistance. The acceptable patch material must, therefore, be impermeable to oxygen and water vapor (e.g. having substantially no pin hole defects), provide good adhesion to the backsheet, be flexible, and in addition be burr-free to prevent possible shorting of the electrical device, which could occur if the patch edge(s) contact the inner metal foil in the backsheet through punctures in the outer layer.

Further provided is a material suitable for establishing and supporting an electrical connection between the adjacent surfaces of the connector cable and the patches on the backsheet. The material used to bond the two surfaces may be a low temperature solder having a melting point temperature below 200°C, e.g. below about 150°C, preferably below about 100°C. The solder may be a single material or an alloy of several suitable materials which are RoHS compliant, and must provide a strong bond between the connector cable and patch.

An associated method of assembling a light panel includes providing a substantially planar light source having a light emitting surface, a backsheet extending in substantially parallel relation therewith, and at least one electrical feed-through region in the backsheet located inwardly from a periphery of the substantially planar light source. Positioned over the electrical feed-through region is a flexible patch allowing an electrical pathway to the light panel as well as maintaining the hermetic seal of the entire device to prevent degradation from water and/or oxygen. Positioning a connector cable over the backsheet, including the patch, is a part of the assembly method so that a first portion of the connector cable extends outwardly of the light source periphery for connection with an associated drive circuit. The method further includes electrically connecting a second portion of the connector cable with the electrical feed-through region of the backsheet through the patch. The electrical connection is established between the connector cable and the patch using a low temperature solder composition that resists delamination, is oxidation resistant, and maintains the flexibility of the light panel.

The method includes insulating conductive traces along a length of the flexible connector cable, and providing plural, spaced apart conductive pads along a surface of the connector cable for establishing electrical contact with similarly spaced electrical feed-through regions in the backsheet, each such region be covered by a patch in accord herewith.

In one embodiment, the light panel is fully laminated, and the electrical connection then provided in a post-lamination step by soldering the conductive pads on the cable to the OLED through the patches provided on the backsheet in the feed-through region.

In another embodiment, the light panel is assembled, including providing solder in the feed-through regions of the backsheet, and during the hermetic encapsulation lamination process step, the solder is flowed to make the electrical connection from the patches to the connector cable.

In yet another embodiment, the backsheet is pre-assembled, including soldering of the cable at the feed-through regions through the patch material, and then the light panel including the pre-assembled backsheet is assembled and laminated.

The electrically connecting step includes filling a feed-through region with a conductive material to establish the electrical contact between the conducting pad and the patches in the feed-through region.

The filling step includes introducing a conductive bonding material such as a low temperature solder between the conductive pads and the patch, and optionally thereafter covering the conductive pad and feed-through region with an electrical insulator.

A primary benefit is the ability to provide an effective, reliable electrical pathway for the panel from a region external of the panel while maintaining flexibility. Yet another benefit is found in the thin profile maintained by the lighting assembly when using a flat flex connector cable, along with the flexibility of the low temperature solder and, if used, the insulator sheet that allow for conformable lighting solutions.

Openings in the conductive pad of the flat flex cable simplify manufacturing, allowing the flat flex cable to be initially positioned, and then a bonding material applied to insure positional accuracy.

The use of low temperature solder bonding material and a compatible patch material provide for processing at temperatures suitable for use with the temperature sensitive OLED panel, while still establishing a reliable, flexible connection between the lighting assembly and an external drive circuit.

In addition to the foregoing, this method provides an option to construct a lighting assembly in a single lamination process, thus providing a more economical assembly, as well as providing for ease in uniformly illuminating a large area, interconnecting multiple devices, and maintaining flexibility of the panel.

Still further, the use of a low temperature solder as disclosed herein for electrically connecting the patch and the connector cable allows for efficient, fast processing at lower temperatures, in keeping with the temperature sensitive processing limits of the OLED, as compared to other known epoxy or tape adhesive arrangements and materials.

Still other benefits and advantages of the present disclosure will become apparent upon reading and understanding the following detailed description of the preferred embodiments.

### BRIEF DESCRIPTION OF THE DRAWINGS

Figure 1 is a plan view of the light emitting surface of a lighting assembly.
Figure 2 is a plan view of a rear surface of a lighting assembly.
Figure 3 is an enlarged plan view of a preferred flat flex cable.
Figure 4 is a plan view of the flat flex cable initially positioned or temporarily secured to the lighting assembly of Figure 2.
Figure 5 is a cross-sectional view taken through a portion of the cable and lighting assembly of Figure 4.
Figure 6 is cross-sectional view similar to Figure 5 after the electrical interconnection has been completed.
Figure 7 is a plan view of a conductive pad as would be found on a flat flex cable.
Figure 8 is a plan view of the rear surface of an OLED lighting assembly.
Figure 9 is a plan view of the OLED lighting assembly of Figure 8 with the flat flex cable shown in mounted arrangement.
Figure 10 is an exploded view of a dual layer encapsulated OLED lighting assembly.

### DETAILED DESCRIPTION OF THE PREFERRED EMBODIMENTS

For purposes of the following description, since the particular details of a generally planar, flexible light source or OLED device are known to those skilled in the art and previously referenced in the Background of the present application, further description herein is deemed unnecessary. Those details required for the present disclosure are provided below and illustrated in the accompanying drawings. As used herein, the term "lighting assembly" refers to any assembly of all or some of the components and materials described herein, including at least a light source, which may be an OLED device or a panel including at least one hermetically encapsulated OLED device, and a low temperature mechanism, for example a low temperature bonding material, in conjunction with a connector cable, for providing electrical power to the assembly. The terms "OLED" and "light source", and variations thereof, may be used interchangeably herein. Though the invention may be described herein with respect to a flexible light assembly, one skilled in the art would understand that the various features and attributes of the disclosure are equally applicable to other lighting solutions. In the Figures provided, like elements of the lighting assembly are denoted with the same reference number in order to provide continuity and understanding.

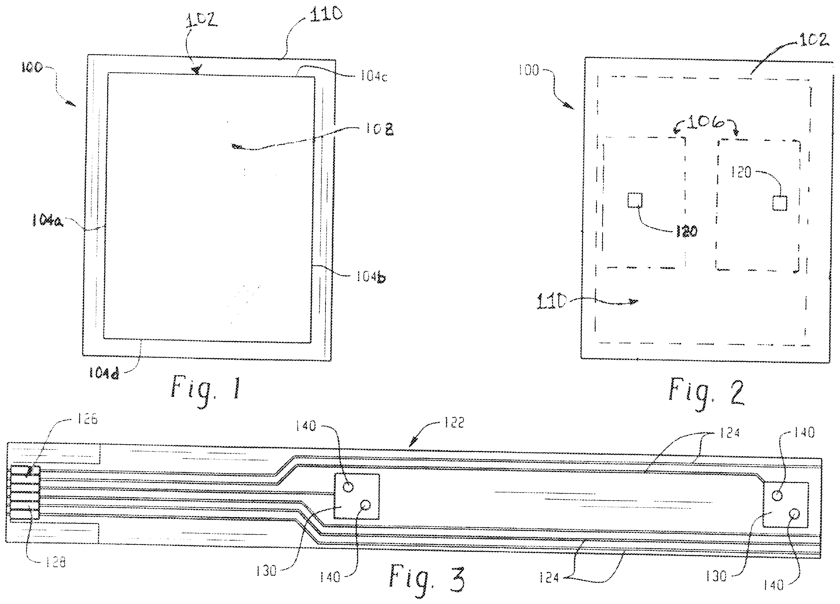

More particularly, and with initial reference to Figure 1, a flexible lighting assembly 100 includes a first surface having a light source 102 having at least one generally planar, light emitting surface 108 that includes a perimeter or edge 104. In the illustrated embodiment, the perimeter edge 104 of light source 102 has a generally quadrilateral conformation or rectangular conformation in which opposite edges are disposed in parallel relation. More particularly, edges 104a, 104b are parallel and edges 104c, 104d are likewise parallel. In this particular embodiment, the first and second edges 104a, 104b are substantially perpendicular to the edges 104c, 104d. Of course, the lighting assembly 100 can adopt a different conformation than that shown in the Figures without departing from the scope and intent of the present application.

With reference to Figure 2, lighting assembly 100 is shown to include a backsheet 110, adjacent that surface of light source 102 opposite light emitting surface 108. Backsheet 110 is preferably formed from an air and moisture impervious material. The backsheet provides support for the light source 102, shown in phantom as it is actually under the backsheet, and, in one preferred embodiment, has a surface area that substantially covers one side or surface of the light source 102. It is also contemplated that the impermeable backsheet is light impermeable in this preferred embodiment, i.e., light is emitted from the enlarged, generally planar surface 108 opposite the backsheet, but one will recognize that in other instances the backsheet may be light transmissive and the back surface may therefore also be a light emitting surface. Light source 102 is preferably hermetically sealed between backsheet 110 and front barrier sheet 116. Thus, as seen in the Figures, the light source 102 is sealed about its entire periphery by an extension of the backsheet, which is adhesively sealed to the front barrier sheet 116. In some instances, the backsheet is co-terminus with the dimensions of the light source while in other instances the backsheet has a frame-like structure that seals about generally annular perimeter portions. More particular details of the perimeter seal do not form a part of the present disclosure and reference may be made to commonly owned, co-pending US application Serial No. 12/691,674, filed January 12, 2010. Details of the flexible cable used to establish electrical connection to the OLED device are found in US Application Serial No. 12/644,520, filed December 22, 2009 .

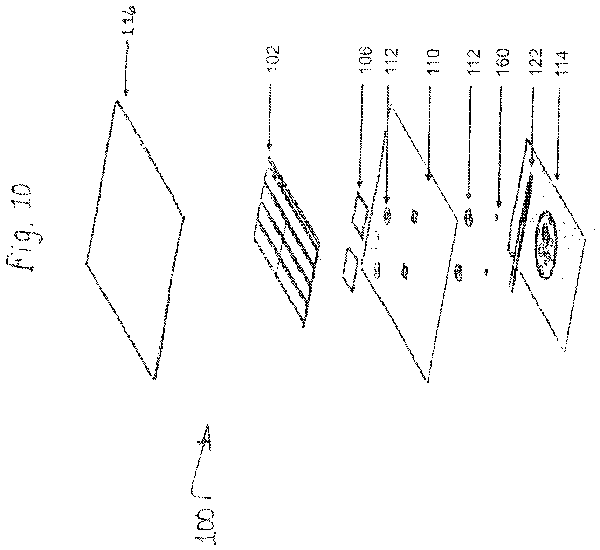

With reference to Figures 2-10, at selected locations in the backsheet 110, at least one and preferably multiple electrical feed-through regions 120 (Figure 2) are provided through the backsheet to the light source for communication with the individual light source, which may be an OLED device, within the lighting assembly 100. Contact patch 106, discussed more fully below, are positioned on the back surface of the light source 102 in the area of the feed-through regions 102 and between the light source 102 and the backsheet 110. The electrical feed-through regions 120 are typically spaced inwardly of the perimeter. It becomes necessary to provide an effective electrical connection with an external driver circuit (not shown). Here, a generally planar or flat, flexible cable 122 interconnects the external circuit with the light source 102 through the feed-through regions 120 and corresponding patches 106. Electrically conductive traces 124 are provided in the cable and extend from a standard connector such as a zero insertion force connector 126, at or adjacent one end of the cable. The connector preferably has exposed electrically conductive portions 128. Suitable connection can be made with the external circuit (not shown) via the connector 126 and electrical current provided through the traces 124 to one or more electrically conductive pads 130 (Figure 3) provided in the cable. As will be appreciated, the spacing between the conductive pads 130, preferably made of tin coated copper or another electrically conductive material, matches that of the dimensional spacing between the electrical feed-through regions in the backsheet of the OLED panel. These conductive pads (130) are preferably double sided (having electrical contact on both top and bottom sides) to aid in maintaining electrical continuity between the flat flex cable and the OLED device. Likewise, the cable 122 has a sufficient dimension so that the connector 126 is preferably located outside the perimeter of the OLED panel where connection can be made with the external circuit. The preferred embodiment is a connector on the outside of the perimeter of the OLED device but other examples can be noted where the connector does not extend past the outside dimension of the device but is instead electrically connected within this periphery. This type of connection method would be necessary where depth behind the OLED device is not a concern and where area outside the periphery of the OLED device is the limiting factor. Except at the exposed conductive portions 128 of the connector, and at the conductive pads 130, the conductive traces 124 are otherwise insulated from one another and from the external environment. For example, the cable can be a thin, polymer or plastic construction that serves to electrically insulate the traces from one another and from the external environment. Additionally, insulator rings 112 (shown in Figure 10) may be added to provide electrical insulation in the area of the connection. With further reference to the cable, a preferred flat flexible cable has a thickness on the order of 10 mils (0.254 mm) or less so that it does not adversely interfere with the flexible nature of the OLED panel. These physical properties of the flexible cable are merely exemplary and should not be deemed limiting.

Between the backsheet 110 and the OLED 102 is patch 106 corresponding to each feed through region 120. Patch 106 may be shown in the Figures in phantom. The patch is comprised of a material that exhibits high bond strength to the low temperature solder contemplated for use in certain embodiments. As such, though aluminum is conventionally used in conjunction with silver epoxy or double-sided conductive tape adhesives, it is not well suited for use herein given that the low temperature solder best suited to use with temperature-limited OLEDs does not adhere well to an aluminum surface. A more suitable patch material is, for example, silver, tin, or copper. In one embodiment, the patch comprises tin coated copper. The copper may be coated with the tin by any known method. For example, it has been discovered that in general a hot coated tin dipping method provides a patch exhibiting the requisite strength and other desirable characteristics. As noted, given the temperature sensitive nature of the OLED device, the patch should be comprised of a material compatible with the low temperature solder preferred for use in the electrical connection herein.

One concern with regard to the foregoing relates to the material used to create the connection, which must be ductile, exhibit a suitable Young's modulus, and have an appropriate coefficient of thermal expansion with regard to a device that operates at temperatures below about 100°C, e.g. below about 80°C.

The patch 106 preferably exhibits certain interface properties, such as providing a durable electrical connection to the solder, low electrical interface resistance, and oxidation resistance. Given those general requirements, tin plated copper is a good candidate material. In addition, the patch material should be substantially free of pinhole defects. Certain metals tend to exhibit pinhole defects when provided in the thin film form required for use herein. The patch material must further exhibit good adhesion to the thermoplastic and pressure sensitive adhesives used in adjacent layers of the hermetically sealed panel, be flexible, and have burr-free edges, so as to reduce the potential for electrical shorting failures. Edges of the patch 106 may be rendered burr-free for example by laser, chemical etching, or any other suitable method.

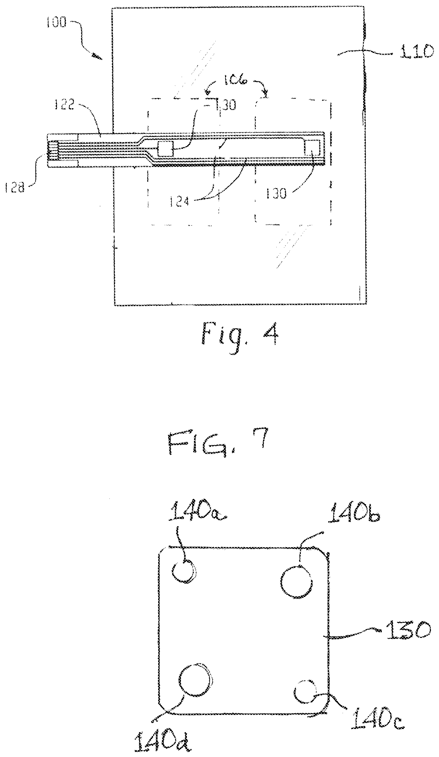

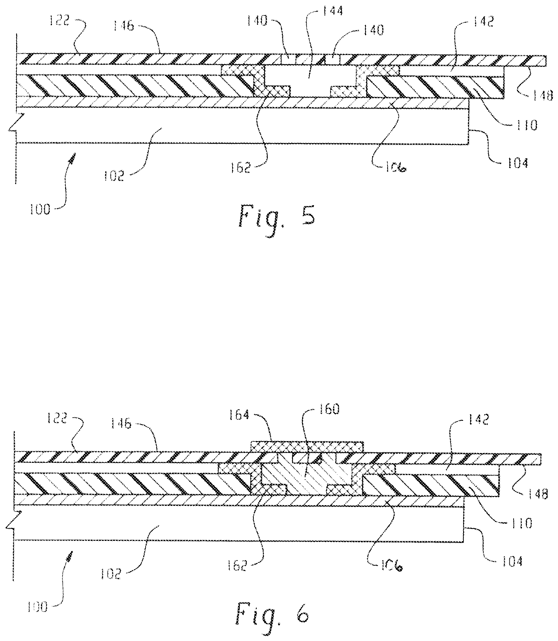

In the preferred embodiment of Figures 3-10, for example, the conductive pads 130 each include one or more openings 140 that extend entirely through the flexible cable. Openings 140 are more clearly shown in Figure 7, providing a plan view of a single conductive pad, in this embodiment having four openings 140a-d located generally in the four corners of the conductive pad 130. It is understood that this particular configuration of openings 140 is merely exemplary and not intended to be in any way limiting with respect to the number or placement of such openings. For example, Figure 3 shows only 2 openings 140 in pads 130. The electrical feed-through regions 120 positioned over patches 106, are open or exposed to the generally planar surfaces of the flat flexible cable. In this manner, the cable 122 is positioned so that the conductive pads 130 are aligned with and overlie the feed-through regions 120 of the OLED panel, and connect thereto through the patches 106. In one embodiment, once properly positioned or aligned as desired, the cable may be held in place. For example, the cable can be temporarily held in place by an external holder, or alternatively an adhesive, which may be either a pressure sensitive adhesive or a thermal adhesive. If the latter is used, the adhesive should be chosen such that the required temperature thereof does not exceed the temperature limitations of the OLEDs. The adhesive can be used on that surface of the flexible cable facing the OLED panel so that the flexible cable is temporarily affixed or tacked to the backsheet. Adhesive 142 is represented in Figures 5 and 6. Any suitable adhesive can be used, although its thickness should be minimized so as not to adversely affect the flexibility of the OLED panel and the flexible cable. It will also be appreciated that the optional adhesive can be located along other regions of the cable so that the adhesive does not interfere with the electrical connection between the pads 130 and the patches 106.

Once temporarily positioned in place as illustrated in Figures 4 and 5, a cavity 144 in the feed-through region 120 is then filled from the outwardly facing surface 146 of the flexible cable (the inwardly facing surface 148 overlays the patch 106 at the feed-through region and is secured to the OLED panel), and the cavity subsequently filled with an electrically conductive material, for example a low temperature solder 160 (Figure 6). While conventional epoxy adhesive systems may be used, they require extended cure times, due to the lower-than-usual processing temperatures dictated by the OLED parameters, and tend to crack and/or delaminate, thus reducing the strength and effectiveness of the electrical connection and reducing the useful life of the device. The low temperature solder material disclosed, however, is processed at a temperature in keeping with the OLED limits, and therefore provides for an immediate electrical connection to be established and further provides greatly improved adhesion. As used herein, the term "low temperature" refers to the temperature necessary to cause the solder to flow, i.e. its melting point, being well below the 280°C temperature generally associated with other solder materials. Table 1 provides a list of exemplary low temperature solder materials, including melting point data. The solder material preferably has a melting point below about 150°C, e.g. below about 100°C, allowing for processing at a temperature in keeping with the temperature sensitive nature of the OLED. Notwithstanding the foregoing, depending on the placement of the feed through connection, i.e. closer to the perimeter of the device/further from the OLED, or on the substrate temperature requirements, higher temperature solder materials may be used, for example up to about 200°C. In addition to the temperature limitations due to the OLED, it is further understood that the melting point of the solder should not exceed the softening point, i.e. glass transition temperature or melting point temperature, of the plastic materials used in the lighting assembly, or that temperature at which the structural integrity of the assembly would be compromised. Further, the processing temperature used during application of the solder, which may be up to 30°C, e.g. 20°C higher than the melting point of the solder, must not adversely affect the lighting assembly materials. Still further, in keeping with RoHS compliance demands, and a desire to provide an environmentally friendly product, the solder material may be free of lead and other hazardous materials.

**TABLE 1**

| **Chemical Composition** | **Liquidus Temperature (°C)** | **Solidus Temperature (°C)** |
|---|---|---|
| 61Ga25In13Sn1Zn | 8 | 7 |
| 66.5Ga20.5In13Sn | 11 | 11 |
| 75.5Ga24.5In | 16 | 16 |
| 62.5Ga21.5In16Sn | 17 | 11 |
| 95Ga5In | 25 | 16 |
| 100Ga | 30 | 30 |
| 49Bi21In18Pb12Sn | 58 | 58 |
| 51In32.5 Bi16.5Sn | 60 | 60 |
| 49Bi18Pb18In15Sn | 69 | 58 |
| 66.3In33.7Bi | 72 | 72 |
| 57Bi26In17Sn | 79 | 79 |
| 54Bi29.7In16.3Sn | 81 | 81 |
| 51.45Bi31.35Pb15.2Sn 2In | 93 | 87 |
| 52Bi31.7Pb15.3Sn1In | 94 | 90 |
| 52.5Bi32Pb15.5Sn | 95 | 95 |
| 52Bi32Pb16Sn | 95.5 | 95 |
| 52Bi30Pb18Sn | 96 | 96 |
| 50Bi31Pb19Sn | 99 | 93 |
| 50Bi28Pb22Sn | 100 | 100 |
| 46Bi34Sn20Pb | 100 | 100 |
| 56Bi22Pb22Sn | 104 | 95 |
| 50Bi30Pb20Sn | 104 | 95 |
| 52.2Bi37.8Pb10Sn | 105 | 98 |
| 45Bi35Pb20Sn | 107 | 96 |
| 46Bi34Pb20Sn | 108 | 95 |
| 52.2In46Sn1.8Zn | 108 | 108 |
| 54.5Bi39.5Pb6Sn | 108 | 108 |
| 67Bi33In | 109 | 109 |
| 51.6Bi41.4Pb7Sn | 112 | 98 |
| 50Bi25Pb25Sn | 115 | 95 |
| 52.98Bi42.49Pb4.53Sn | 117 | 103 |
| 52In48Sn | 118 | 118 |
| 53.75Bi43.1Pb3.15Sn | 119 | 108 |
| 55Bi44Pb1Sn | 120 | 117 |
| 55Bi44Pb1In | 121 | 120 |
| 55.5Bi44.5Pb | 124 | 124 |
| 50In50Sn | 125 | 118 |
| 58Bi42Pb | 126 | 124 |
| 38Pb37Bi25Sn | 127 | 93 |
| 51.6Bi37.4Sn6In5Pb | 129 | 95 |
| 40In40Sn20Pb | 130 | 121 |
| 52Sn48In | 131 | 118 |
| 34Pb34Sn32Bi | 133 | 96 |
| 56.84Bi41.16Sn2Pb | 133 | 128 |
| 38.41Bi30.77Pb30.77Sn0.05Ag | 135 | 96 |
| 57.42Bi41.58Sn1Pb | 135 | 135 |
| 36Bi32Pb31Sn1Ag | 136 | 95 |
| 55.1Bi39.9Sn5Pb | 136 | 121 |
| 36.5Bi31.75Pb31.75Sn | 137 | 95 |
| 43Pb28.5Bi28.5Sn | 137 | 96 |
| 58Bi42Sn | 138 | 138 |
| 38.4Pb30.8Bi30.8Sn | 139 | 96 |
| 57Bi42Sn1Ag | 140 | 139 |
| 33.33Bi33.34Pb33.33Sn | 143 | 96 |
| 97In3Ag | 143 | 143 |
| 58Sn42In | 145 | 118 |
| 80In15Pb5Ag | 149 | 142 |
| 99.3In0.7Ga | 150 | 150 |
| 95In5Bi | 150 | 125 |
| 90In10Sn | 151 | 143 |
| 42Pb37Sn21Bi | 152 | 120 |
| 99.4In0.6Ga | 152 | 152 |
| 99.6In0.4Ga | 153 | 153 |
| 99.5In0.5Ga | 154 | 154 |
| 100In | 156.7 | 156.7 |
| 54.55Pb45.45Bi | 160 | 122 |
| 70Sn18Pb12In | 162 | 162 |
| 48Sn36Pb16Bi | 162 | 140 |
| 43Pb43Sn14Bi | 163 | 144 |
| 50Sn40Pb10Bi | 167 | 126 |
| 51.5Pb27Sn21.5Bi | 170 | 131 |
| 60Sn40Bi | 170 | 138 |
| 50Pb27Sn20Bi | 173 | 130 |
| 70In30Pb | 175 | 165 |
| 47.47Pb39.93Sn12.6Bi | 176 | 146 |
| 62.5Sn36.1Pb1.4Ag | 179 | 179 |
| 60Sn25.5Bi14.5Pb | 180 | 96 |
| 37.5Pb37.5Sn25In | 181 | 134 |
| 86.5Sn5.5Zn4.5In3.5Bi | 186 | 174 |
| 77.2Sn20In2.8Ag | 187 | 175 |
| 83.6Sn8.8In7.6Zn | 187 | 181 |
| 91Sn9Zn | 199 | 199 |
| 86.9Sn10In3.1Ag | 205 | 204 |
| 91.8Sn4.8Bi3.4Ag | 213 | 211 |
| 90Sn10Au | 217 | 217 |
| 95.8Sn3.5Au0.7Cu | 220 | 217 |
| 95.5Sn3.9Ag0.6Cu | 220 | 217 |

In addition, the solder material exhibits a suitable Young's modulus, and a coefficient of thermal expansion (CTE) that is compatible with the other materials at the connection interface. Young's modulus, which is a ratio of stress to strain, or a measure of the stiffness of a material, is generally represented in terms of pressure, i.e. GPa. Suitable solder materials exhibit a Young's modulus consistent with a high degree of flexibility, e.g. 2-150 GPa, e.g. 5-50 GPa.

Also important is the CTE of the solder material and its compatibility with the other materials in the region of the electrical connection. The materials used in the different components of the system will expand and contract in response to heat generated during processing or during use over the life of the device in accord with the CTE of each. Therefore, the patch material and solder, as well as the pads of the flat flex cable, should have comparable CTE values. A thermal mismatch between adjacent materials may quickly degrade the electrical connection, by causing, for example, cracking or delamination in response to unequal stretching and/or compression caused by reaction of each different material to heat. For example, a CTE match within 150%, e.g. within 50%, e.g 20% or less is desirable. TABLE 2 below provides Young's modulus and CTE data for patch and solder material components in accord with the disclosure.

**TABLE 2**

| | CTE (1/K) | Y (GPa) |
|---|---|---|
| Sn | 22 x10⁻⁶ | 50 |
| In | 32.1 x10⁻⁶ | 11 |
| Bi | 13.4 x10⁻⁶ | 32 |
| Cu | 16.5 x10⁻⁶ | 130 |
| Ag | 18.9 x10⁻⁶ | 83 |
| Au | 14.2 x10⁻⁶ | 78 |
| Ni | 13.4 x10⁻⁶ | 200 |
| Zn | 30.2 x10⁻⁶ | 108 |

The low temperature solder material 160 substantially fills the cavity 144 and is in electrical contact with patch 106 that is, in turn, in electrical contact with a conductive portion of the OLED device 102. Portions of the cavity 144 may be lined with the insulating material 162. In one embodiment, the low temperature solder 160 is introduced from the outwardly facing surface 146 of the flat flexible cable, through the openings 140 in the conductive pad 130 and into the cavity 144 (Figure 5). In another embodiment, the solder is first introduced in between the conductive pad 130 and patch 106, and allowed to flow through the holes to the upper surface of the pad. The soldering process may be accomplished using conventional solder techniques, or by using laser, ultrasonic, hot air, heated chamber, or any other technique known to those skilled in the art for providing such connection.

As shown in Figure 6, the structure may optionally include insulator portion 164, which overlies the low temperature solder material. The insulator not only adds to the mechanical stability and strength of the system, but also prevents electrical shorting failures due to contact with conductive surfaces, and eliminates any contact of the electrical interconnection with the air, thus providing an additional source of oxidation resistance. Alternatively, the insulator may take the form of a full flexible sheet of material 114, such as that shown in Figure 10, which completely covers the backsheet and flexible cable. The insulator can be a pressure sensitive, solvent, or UV cured material that still maintains sufficient flexibility once it is cured. As a result, the combination of the flat, flexible connector cable 122, the patch 106, and the low temperature solder 160, as well as the insulator, whether in the form of portion 164 and/or sheet 114, is effectively mechanically and electrically connected to the OLED panel, and in a manner that does not inhibit overall flexibility of the assembly.

As has been noted, it is important that the materials used have comparable and compatible CTE's and exhibit acceptable flexible, ductile behavior. By using the system and device as structured in accord with the foregoing, the electrical connection can be precisely located, and yet the final assembly is effectively hermetically sealed from the external environment. Electrical continuity is created through the back of the OLED panel to the rest of the system, i.e., through the backsheet and the patch, without compromising the remainder of the structure. The end connector is then a simple, one-stage connection that can be used to connect all of the individual OLED devices that comprise the panel to the rest of the electrical system. By individually addressing electrical feed-through regions 120, individual OLED devices can be individually addressed. For example, a device may need to be tuned and thus one OLED device treated differently than another OLED device in the lighting assembly.

The lighting assembly disclosed herein may be assembled in accord with the following procedural example to ensure that a quality electrical connection is established. It is understood, however, that this example is not intended to be limiting with regard to the assembly or system, but rather provides one manner of assembling the disclosed system using the low temperature solder and patch materials, in conjunction with a flat flex cable, to establish a path for electrical connection of the lighting assembly. Other methods or processes known to those skilled in the art may be employed.

Example 1: Low Temperature Solder Process. This Example may be understood best with reference to Figure 10 providing an exploded view of one embodiment of a finished device in accord herewith. In particular, this process demonstrates the use of low temperature solder 160 to connect a flat flex cable 122 to patch 106 of lighting assembly 100. In this example, two different low temperature solder compositions were obtained from Indium Corporation. The first was an alloy of In(51)-Bi(32.5)-Sn(16.5), having a liquidus temperature (melting point) of 61°C, and the second was an alloy having the composition Bi(57)-In(26)-Sn(17), with a liquidus temperature of 79°C. The patch material comprised hot tin dipped copper, available commercially from All Foils, Inc., cut to 30mm x 60mm dimensions and rendered burr-free. The flat flex cable included tin coated copper connection pads, generally in accord with that shown in Figure 5. Other materials included flux, commercially available from Indium Corporation as PoP Flux 30B, used to maintain clean, oxide-free material surfaces necessary to establishing electrical connections and solder joints, and 2-propanol, which is used to clean all surfaces prior to the solder process. The soldering was done using a Weller WD1 Digital 85W Soldering Station Power Unit, 120V.

Prior to actually soldering the materials to create an electrical path, all materials were carefully cleaned. Any dirt or grease that gets onto the materials, even from human contact, will cause reduce adherence of the solder to the contact patch and consequently degrade strength and durability causing connection problems in the resulting device. In order to avoid such problems, the materials were first cleaned with 2-propanol, i.e. both sides of the connection pads, and the exposed contact patch regions, being careful not to get excess alcohol on the backsheet of the hermetic OLED panel as this may cause delamination. It is also important to maintain an oxidation-free soldering tip, as any residual oxidation may work its way into the solder joint and degrade the same. Therefore, the solder iron tip was cleaned continually throughout the following processing.

Once the materials are properly prepared, the Weller soldering station is preheated. For the 61°C solder, the soldering station was used at 120°C, and for the 79°C solder the station was set to 160°C. A small amount of room temperature flux was applied to the contact patch and preheated using the soldering iron until it was more liquid. In order to achieve a good connection between the solder and the contact patch, the patch should be at or about the same temperature as the solder. It is also important throughout the following process to continually clear any oxidative or material build-up from the tip of the solder iron. When the patch was at or about the same temperature as the solder, the solder was applied to the patch using the solder iron tip. If the solder does not adhere immediately, continued application of heat from the solder iron may be used. Unbonded solder will have the appearance of a ball, while bonded solder will appear more like a drop of liquid/water. Enough solder should be applied to cover the exposed patch region. Because the solder hardens almost immediately, it was important to immediately place the connection pad of the flat flex cable over the solder joint. Continued application of heat from the solder iron tip was used to keep the solder from completely hardening prematurely. After placement of the cable connection pad over the solder joint, heat was continued to the top surface of the connection pad, causing the solder to flow through the holes in the connection pad (see Figure 5). The solder was allowed to flow until it pooled on top of the connection pad, and was then spread using the solder iron tip to cover completely the connection pad surface. Residual flux was removed using 2-propanol. As one skilled in the art may know, the pressure used to affect an acceptable solder joint is critical, as too much pressure may result in deformation of the contact patch surface.

The foregoing processing was used to create two electrical connection samples, one using the 61°C solder (Sample A), applied at 120°C, and one using the 79°C solder (Sample B), applied at 160°C. In addition, two more samples were prepared, one using a silver epoxy adhesive (Sample C) and one using double-sided Z-tape as the adhesive mechanism (Sample D). Samples C and D were both prepared at room temperature in accord with conventional processing for such materials, i.e. the various components were assembled, with the silver epoxy or Z-tape applied to bond the electrical connection materials. Samples A and B were prepared using tin coated copper patch material given that the low temperature solder did not adhere well to plain aluminum patch material, which might be conventionally used in order to retain the flexible nature of the over-all device. Moreover, it was found that the processing used to prepare the patch material had an affect on the quality of the connection. Vapor deposited tin coated copper had a rougher surface that did not allow for quality bonding. Therefore, it was determined that hot tin dipped copper had a smoother surface and thus allowed for a much better bonding surface. This material, obtained from All Foils, Inc., was cut to the desired dimension (30mm x 60mm) and then finished to remove any defects from the edges of the material, rendering the patches burr-free.

The contact patches, processed in accord with the foregoing, were laminated to a backsheet made from Tolas TPC-0814B lidding foil, which is a multi-layer barrier material available commercially from Oliver-Tolas Healthcare Packaging. In addition, insulator rings were attached to the backsheet in the region of the electrical feed through and connection. Next, the flat flex cable having connection pads, as described herein, was attached using material A, B, C and D, generating four samples.

Each sample was next attached to a metal plate using double sided tape, and the flat flex cable was extended using additional tape. In order to test the ability of the connection material to resist stress and strain, each sample was loaded into a Chatillon TCM201 motorized force tester. The samples were tested in a shear pull method and also in a 180° peel test method. Both tests were conducted at a pull speed of 1 inch/minute (2.54 cm/minute).

The following Tables 3-6 provide the data obtained during these tests. As can be seen, the average force at which the two soldered samples, A and B, failed was significantly higher than that at which the silver epoxy and Z-tape adhesives failed, for both test methods. This indicates that the low temperature solder adhesive system will provide greatly enhanced
performance with regard to durability and flexibility of the OLED device without experiencing failure due to delamination or other structural failure.

**Table 3**

| **79°C Solder** | | | |
|---|---|---|---|
| **Shear Strength** | | **180° Pull Test** | |
| **Force (lbf)** | **Failure Description** | **Force (lbf)** | **Failure Description** |
| 22.8 | failed at flex cable | 9.4 | failed at flex cable |
| 19.4 | failed at flex cable | 6.8 | failed at flex cable |
| 20.3 | failed at flex cable | 10.1 | failed at flex cable |
| | | | |
| Average force: 20.8 lbf | | Average force: 8.8 lbf | |
| Std. Dev. 1.76 | | Std. Dev. 1.74 | |

**Table 4**

| **61°C Solder** | | | |
|---|---|---|---|
| **Shear Strength** | | **180° Pull Test** | |
| **Force (lbf)** | **Failure Description** | **Force (lbf)** | **Failure Description** |
| 19.4 | failed at flex cable | 5.9 | failed at solder interface |
| 22.0 | failed at flex cable | 6.8 | failed at solder interface |
| 21.1 | failed at flex cable | 7.7 | failed at solder interface |
| | | | |
| Average force: 20.8 lbf | | Average force: 6.8 lbf | |
| Std. Dev. 1.32 | | Std. Dev. 0.90 | |

**Table 5**

| **Silver Epoxy** | | | |
|---|---|---|---|
| **Shear Strength** | | **180° Pull Test** | |
| **Force (lbf)** | **Failure Description** | **Force (lbf)** | **Failure Description** |
| 10.1 | failed at epoxy interface | 1.6 | failed at epoxy interface |
| 12.8 | failed at epoxy interface | 1.8 | failed at epoxy interface |
| 14.2 | failed at epoxy interface | 2.5 | failed at epoxy interface |
| | | | |
| Average force: 12.4 lbf | | Average force: 1.9 lbf | |
| Std. Dev. 2.08 | | Std. Dev. 0.47 | |

**Table 6**

| **Z-Tape** | | | |
|---|---|---|---|
| **Shear Strength** | | **180° Pull Test** | |
| **Force (lbf)** | **Failure Description** | **Force (lbf)** | **Failure Description** |
| 9.3 | failed at tape interface | 1.7 | failed at tape interface |
| 8.7 | failed at tape interface | 1.3 | failed at tape interface |
| 11.8 | failed at tape interface | 1.1 | failed at tape interface |
| | | | |
| Average force: 9.9 lbf | | Average force: 1.4 lbf | |
| Std. Dev. 1.64 | | Std. Dev. 0.31 | |

In addition to the foregoing, it has been determined that the optional addition of a thermocouple on the back side of the contact patch helps to maintain an OLED temperature below the 120°C limit of the panel. With the thermocouple in place, sample in accord with A and B above were tested and it was determined that the patch in sample B (79°C solder) experienced a maximum temperature of 85°C, and the patch in sample A (61°C solder) experienced a maximum temperature of 74°C. In both samples, no visible defects were detected.

The thin profile of the flat flexible cable 122, along with the flexibility of the patch 106 and the low temperature solder 160, and optionally the insulator cap 164/rings 112/and or sheet 114 where used, still allows the OLED panel to be adapted for use in conformable lighting solutions. The corresponding openings in the connector pad of the flat flex cable and the patch assist in manufacture/assembly of the OLED panel. In one embodiment, the low temperature soldering process is completed post lamination, i.e. the various layers of the OLED device, which may for example be a dual layer encapsulated device, are laminated, followed by low temperature processing to flow the low temperature solder, which is present on the patch, through the holes in the connection pad(s) of the flat flex cable to the feed through openings to create the requisite electrical connection. Alternatively, the entire OLED package, shown in an exploded view in Figure 10, may be assembled, with the solder composition placed in the feed-through region(s) and on the connection pad(s), such that upon lamination of the device the solder melts and flows to create the electrical connection between the OLED and the external power source through the flat flex cable. In yet another embodiment, the flat flex cable is first soldered to the backsheet, followed by the application of the backsheet/flat flex cable to the assembled device for subsequent lamination. By using this latter method, it may be possible to avoid the OLED temperature constraints, but this must be weighed against the stress concentrators that may be created during lamination of the OLED device due to the added thickness of the flat flex cable.

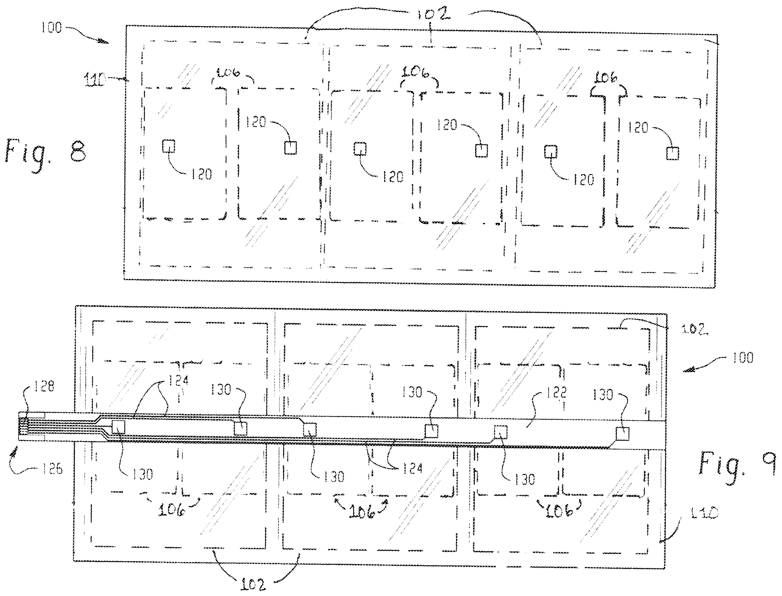

The embodiment of Figures 8 and 9, and the exploded view presented in Figure 10, are substantially identical to that of Figures 2-6. Therefore, like elements are referenced with like reference numerals for consistency and brevity of discussion. More particularly, Figure 8 further demonstrates that the light panel may be comprised of multiple OLED devices. The flat flexible cable and manner of establishing electrical continuity through a rear face of the hermetic package is particularly and advantageously illustrated here. That is, electrical feed-through regions 120, covered by patches 106, are provided in each of the OLED device portions. The flexible cable 122 includes conductive pads 130 at the same dimensional spacing as the patch and feed-through regions. Thereafter, the mechanical and electrical interconnection is completed as described above with respect to Figures 2-6 and as applied to the multiple OLED device portions of Figures 8 and 9. In this manner, the flexible cable is able to provide electrical continuity from the external driver or circuit, along the conductive traces, to individual feed-through regions 120, and also, partially due to the patch materials and the positioning thereof, effectively bridge hermetically sealed regions disposed between individual OLED device portions. Figure 10 provides an exploded view of a complete dual layer encapsulated OLED, including insulator sheet 114, flat flex cable 122, low temperature solder 160 providing electrical connection through patch 106 to OLED 102, which is hermetically sealed between the front barrier sheet 116 and the backsheet 110. It is understood, however, that while the invention has at times been described with reference to such a dual layer encapsulated device, the materials and processing techniques disclosed herein will find equal application to non-encapsulated devices. For example, in such a device, the patch may be replaced by a suitable transparent polymer conductor or conductive oxide, appropriately placed on the OLED to provide the necessary electrical connection, and the solder composition operatively connected to this conductor.

## Claims

1. A lighting assembly (100) comprising:
a light source (102) having a first generally planar, light emitting surface including a perimeter edge, a backsheet (110) disposed in substantially parallel relation with the light emitting surface, at least one electrical feedthrough region (120) extending through the backsheet (110) and each feedthrough region (120) substantially covered by a contact patch disposed in substantially planar relation between the light source and the backsheet, wherein the light source (102) is an OLED comprising a cathode layer, an anode layer, and an organic layer between the cathode and anode layers;
a generally planar, connector cable (122) extending over the backsheet (110) from a perimeter thereof to the contact patch covering the at least one electrical feedthrough region (120) and having at least one connector pad positioned on the connector cable (122) to associate with each at least one electrical feedthrough to the light source through the contact patch; and
a low temperature solder material (160) disposed between each connector pad and contact patch for establishing electrical connection with the light source (102), wherein one or more of the light source, connector cable, backsheet, or any portion thereof is constructed of one or more plastics.

2. The lighting assembly of claim 1 wherein the low temperature solder (160) has a melting point lower than the softening point of the plastics included in the lighting assembly (100).

3. The lighting assembly of claim 1 wherein the low temperature solder (160) has a melting point of less than about 200°C.

4. The lighting assembly of claim 1 wherein the contact patch and the solder comprise materials that are compatible with respect to surface adhesion, coefficient of thermal expansion, and Young's modulus, such that the lighting assembly exhibits a flexible nature without experiencing delamination.

5. The lighting assembly of claim 4 wherein the contact patch material exhibits a coefficient of thermal expansion within 150% of the coefficient of thermal expansion of the low temperature solder.

6. The lighting assembly of claim 4 wherein the contact patch material and the low temperature solder each exhibit a Young's modulus of 2-150 GPa.

7. The lighting assembly of claim 1 wherein the contact patch comprises tin, nickel, gold, silver, copper, or a combination thereof, and the solder comprises at least two of indium, bismuth, tin, lead, silver and zinc.

8. The lighting assembly of claim 1 wherein the lighting assembly (100) is RoHs compliant, and the contact patch comprises hot tin dipped copper and the low temperature solder (160) is selected from the group consisting of In(51)Bi(32.5)Sn(16.5) having a melting point of 60°C, In(66.3)Bi(33.7) having a melting point of 72°C, Bi(57)In(26)Sn(17) having a melting point of 79°C, Bi(54)In(29.7)Sn(16.3) having a melting point of 81°C, In(52.2)Sn(46)Zn(1.8) having a melting point of 108°C, Bi(67)In(33) having a melting point of 109°C, and In(52)Sn(48) having a melting point of 118°C.

9. The lighting assembly of claim 1 wherein the connector cable (122) is flexible.

10. The lighting assembly of claim 1 further comprising a front barrier sheet disposed in substantially parallel relation with and adjacent the light source (102) and adhesively sealed to the backsheet (110), thereby hermetically encapsulating the light source (102) within the lighting assembly (100).

11. A method of establishing a path for an electrical connection in a lighting assembly (100) comprising:
providing a substantially planar light source (102) having a light emitting surface, a backsheet (110) extending in substantially parallel relation therewith, at least one electrical feedthrough region (120) in the backsheet (110), and each feedthrough region (120) substantially covered by a contact patch disposed in substantially planar relation between the light source and the backsheet, wherein the light source (102) is an OLED comprising a cathode layer, an anode layer, and an organic layer between the cathode and anode layers;
providing a connector cable (122) having a first portion for connection to the light source (102) and a second portion for connection with an associated drive circuit, wherein the first portion comprises at least one connection pad for establishing an electrical connection with the light source;
positioning the at least one connection pad of the connector cable (122) over the patch at the at least one feedthrough region (120) of the backsheet (110); and
flowing a low temperature solder (160) between the at least one connection pad and the patch to establish a path for electrically connecting the light source (102) and the associated drive circuit, wherein one or more of the planar light source, connector cable, backsheet, or any portion thereof is constructed of one or more plastics.

12. The method of claim 11 wherein the lighting assembly (100) is fully laminated, and the path for electrically connecting the light source (102) and the associated drive circuit then provided in a post-lamination step by flowing solder between the at least one connection pad on the connector cable the contact patch on the backsheet (110).

13. The method of claim 11 wherein the lighting assembly (100) is assembled, including providing low temperature solder (160) between the connection pad and the contact patch, and during a further hermetic encapsulation lamination process step, the solder is flowed to provide the path for electrically connecting the light source (102) and the associated drive circuit.

14. The method of claim 11 wherein the backsheet (110) is pre-assembled, including flowing of the low temperature solder (160) between the connection pad and the contact patch, followed by assembly and lamination of the pre-assembled backsheet (110) with the remaining parts of the lighting assembly.

## Patentansprüche

1. Beleuchtungsanordnung (100) mit:
einer Lichtquelle (102) mit einer ersten im Allgemeinen planen, Licht aussendenden Oberfläche einschließlich einer Umfangskante, einer Rückschicht (110), die in einer im Wesentlichen parallelen Beziehung mit der Licht aussendenden Oberfläche angeordnet ist, wenigstens einer elektrischen Durchführungsregion (120), die sich durch die Rückschicht (110) erstreckt und wobei jede Durchführungsregion (120) im Wesentlichen durch ein Kontakt-Patch bedeckt ist, das in einer im Wesentlichen planaren Beziehung mit der Lichtquelle und der Rückschicht angeordnet ist, wobei die Lichtquelle (102) eine OLED mit einer Kathodenschicht, einer Anodenschicht, und einer organischen Schicht zwischen der Kathoden- und der Anodenschicht ist;
einem im Allgemeinen planen, Verbindungskabel (122), das sich über die Rückschicht (110) von deren Umfang zu dem Kontakt-Patch, welches die wenigstens eine elektrische Durchführungsregion (120) bedeckt, erstreckt und wenigstens ein Verbinder-Pad aufweist, das auf dem Verbindungskabel (122) angeordnet ist, um mit jeder der wenigstens einen elektrischen Durchführung zu der Lichtquelle durch das Kontakt-Patch in Verbindung zu gelangen; und
ein Niedrigtemperaturlötmaterial (160), das zwischen jedem Verbinder-Pad und Kontakt-Patch zum Herstellen einer elektrischen Verbindung mit der Lichtquelle (102) angeordnet ist, wobei eine oder mehrere der Lichtquellen, des Verbindungskabels, der Rückschicht oder eines beliebigen Teils davon aus einem oder mehreren Kunststoffen konstruiert ist.

2. Beleuchtungsanordnung gemäß Anspruch 1, wobei das Niedrigtemperaturlot (160) einen Schmelzpunkt geringer als der Erweichungspunkt der Kunststoffe, die in der Beleuchtungsanordnung (100) enthalten sind, aufweist.

3. Beleuchtungsanordnung gemäß Anspruch 1, wobei das Niedrigtemperaturlot (160) einen Schmelzpunkt niedriger als ungefähr 200°C aufweist.

4. Beleuchtungsanordnung gemäß Anspruch 1, wobei das Kontakt-Patch und das Lot Materialien aufweisen, die kompatibel im Hinblick auf Oberflächenhaftung, thermischen Ausdehnungskoeffizienten und Young's-Modul derart kompatibel sind, dass die Beleuchtungsanordnung derart flexibel ist, dass keine Schichtablösung auftritt.

5. Beleuchtungsanordnung gemäß Anspruch 4, wobei das Kontakt-Patch-Material einen thermischen Ausdehnungskoeffizient innerhalb 150% des thermischen Ausdehnungskoeffizienten des Niedrigtemperaturlots zeigt.

6. Beleuchtungsanordnung gemäß Anspruch 4, wobei das Kontakt-Patch-Material und das Niedrigtemperaturlot jeweils ein Young's-Modul von 2 bis 150 GPa zeigt.

7. Beleuchtungsanordnung gemäß Anspruch 1, wobei das Kontakt-Pad aufweist Zinn, Nickel, Gold, Silber, Kupfer, oder eine Kombination davon, und das Lot aufweist wenigstens zwei von Indium, Wismut, Zinn, Blei, Silber und Zink.

8. Beleuchtungsanordnung gemäß Anspruch 1, wobei die Beleuchtungsanordnung (100) RoHs konform ist, und das Kontakt-Pad in heißes Zinn getauchtes Kupfer aufweist und das Niedrigtemperaturlot (160) eines ist aus der Gruppe, die besteht aus In(51)Bi(32,5)Sn(16,5) mit einem Schmelzpunkt von 60°C, In(66,3)Bi(33,7) mit einem Schmelzpunkt von 72°C, Bi(57)In(26)Sn(17) mit einem Schmelzpunkt von 79°C, Bi(54)In(29.7)Sn(16,3) mit einem Schmelzpunkt von 81°C, In(52,2)Sn(46)Zn(1,8) mit einem Schmelzpunkt von 108°C, Bi(67)In(33) mit einem Schmelzpunkt von 109°C, und In(52)Sn(48) mit einem Schmelzpunkt von 118°C.

9. Beleuchtungsanordnung gemäß Anspruch 1, wobei das Verbindungskabel (122) flexibel ist.

10. Beleuchtungsanordnung gemäß Anspruch 1 weiter mit einer Frontsperrschicht, die in einer im Wesentlichen parallelen Beziehung mit und benachbart der Lichtquelle (102) angeordnet ist und adhäsiv an die Rückschicht (110) gedichtet ist, wobei dadurch die Lichtquelle (102) in der Beleuchtungsanordnung (100) hermetisch eingekapselt wird.

11. Verfahren zum Herstellen eines Pfads für eine elektrische Verbindung in einer Beleuchtungsanordnung (100) mit:
Bereitstellen einer im Wesentlichen planaren Lichtquelle (102) mit einer Licht aussendenden Oberfläche, einer Rückschicht (110), die sich in im Wesentlichen einer parallelen Beziehung damit erstreckt, wenigstens einer elektrischen Durchführungsregion (120) in der Rückschicht (110) und jede Durchführungsregion (120) im Wesentlichen bedeckt durch ein Kontakt-Patch, das in einer im Wesentlichen planen Beziehung zwischen der Lichtquelle und der Rückschicht angeordnet ist, wobei die Lichtquelle (102) eine OLED ist, die eine Kathodenschicht, eine Anodenschicht und eine anorganische Schicht zwischen der Kathoden- und der Anodenschicht aufweist;
Bereitstellen eines Verbindungskabels (122) mit einem ersten Teil zum Verbinden mit der Lichtquelle (102) und einem zweiten Teil zum Verbinden mit einer zugeordneten Treiberschaltung, wobei der erste Teil wenigstens einen Verbinder-Pad zum Herstellen einer elektrischen Verbindung mit der Lichtquelle aufweist;
Positionieren des wenigstens einen Verbinder-Pads des Verbindungskabels (122) über dem Patch an der wenigstens einen Durchführungsregion (120) der Rückschicht (110); und
Fließenlassen eines Niedrigtemperaturlots (160) zwischen das wenigstens eine Verbinder-Pad und das Patch, um einen Pfad zum elektrischen Verbinden der Lichtquelle (102) und der zugeordneten Treiberschaltung herzustellen, wobei eine oder mehrere der planaren Lichtquelle, des Verbindungskabels, der Rückschicht, oder eines beliebigen Teils davon aus einem oder mehreren Kunststoffen konstruiert ist.

12. Verfahren gemäß Anspruch 11, wobei die Beleuchtungsanordnung (100) vollständig laminiert ist, und der Weg zum elektrischen Verbinden der Lichtquelle (102) und der zugeordneten Treiberschaltung dann in einem Nachlaminationsschritt durch Fließenlassen von Lot zwischen das wenigstens eine Verbinder-Pad auf dem Verbindungskabel und dem Kontakt-Patch auf der Rückschicht (110) bereitgestellt wird.

13. Verfahren gemäß Anspruch 11, wobei die Beleuchtungsanordnung (100) zusammengefügt wird einschließlich Bereitstellen eines Niedrigtemperaturlots (160) zwischen dem Verbinder-Pad und dem Kontakt-Patch und während eines weiteren hermetischen Einkapslungslaminationsvorgangsschritts, wobei das Lot fließt, um den Pfad zum elektrischen Verbinden der Lichtquelle (102) und der dazugehörigen Treiberschaltung bereitzustellen.

14. Verfahren gemäß Anspruch 11, wobei die Rückschicht (110) vorzusammengebaut wird einschließlich Fließenlassen des Niedrigtemperaturlots (160) zwischen das Verbinder-Pad und das Kontakt-Patch gefolgt durch Zusammenbauen und Laminieren der vorzusammengebauten Rückschicht (110) mit verbleibenden Teilen der Beleuchtungsanordnung.

## Revendications

1. Assemblage d'éclairage (100) comprenant :
une source de lumière (102) qui comporte une première surface d'émission de lumière de forme générale plane qui inclut un bord périmétrique, une feuille arrière (110) qui est disposée selon une relation sensiblement parallèle par rapport à la surface d'émission de lumière, au moins une région d'alimentation électrique traversante (120) qui s'étend au travers de la feuille arrière (110), chaque région d'alimentation électrique traversante (120) étant sensiblement recouverte par un patch de contact qui est disposé selon une relation sensiblement plane entre la source de lumière et la feuille arrière, dans lequel la source de lumière (102) est une OLED qui comprend une couche de cathode, une couche d'anode et une couche organique entre les couches de cathode et d'anode ;
un câble de connecteur de forme générale plane (122) qui s'étend au-dessus de la feuille arrière (110) depuis son périmètre jusqu'au patch de contact qui recouvre l'au moins une région d'alimentation électrique traversante (120) et qui comporte au moins un plot de connexion qui est positionné sur le câble de connecteur (122) de manière à réaliser une association avec chaque au moins une région d'alimentation électrique traversante sur la source de lumière par l'intermédiaire du patch de contact ; et
un matériau de soudure basse température (160) qui est disposé entre chaque plot de connexion et chaque patch de contact pour établir une connexion électrique avec la source de lumière (102), dans lequel un ou plusieurs élément(s) constitutif(s) pris parmi la source de lumière, le câble de connecteur, la feuille arrière ou une quelconque partie afférente est/sont construit(s) à partir d'une ou de plusieurs matière(s) plastique(s).

2. Assemblage d'éclairage selon la revendication 1, dans lequel le matériau de soudure basse température (160) présente un point de fusion plus bas que le point de ramollissement des matières plastiques qui sont incluses dans l'assemblage d'éclairage (100).

3. Assemblage d'éclairage selon la revendication 1, dans lequel le matériau de soudure basse température (160) présente un point de fusion qui est inférieur à environ 200 °C.

4. Assemblage d'éclairage selon la revendication 1, dans lequel le patch de contact et la soudure comprennent des matériaux qui sont compatibles en ce qui concerne l'adhérence en surface, le coefficient de dilatation thermique et le module de Young, de telle sorte que l'assemblage d'éclairage présente une nature flexible sans qu'il ne subisse une déstructuration de la stratification.

5. Assemblage d'éclairage selon la revendication 4, dans lequel le matériau du patch de contact présente un coefficient de dilatation thermique qui se situe à l'intérieur de 150 % du coefficient de dilatation thermique du matériau de soudure basse température.

6. Assemblage d'éclairage selon la revendication 4, dans lequel le matériau du patch de contact et le matériau de soudure basse température présentent chacun un module de Young de 2 - 150 GPa.

7. Assemblage d'éclairage selon la revendication 1, dans lequel le patch de contact comprend de l'étain, du nickel, de l'or, de l'argent, du cuivre ou une combinaison de ceux-ci, et la soudure comprend au moins deux éléments pris parmi l'indium, le bismuth, l'étain, le plomb, l'argent et le zinc.

8. Assemblage d'éclairage selon la revendication 1, dans lequel l'assemblage d'éclairage (100) est conforme à la directive RoHs, et le patch de contact comprend du cuivre étamé à chaud et le matériau de soudure basse température (160) est sélectionné parmi le groupe qui est constitué par l'In(51)Bi(32,5)Sn(16,5) qui présente un point de fusion de 60 °C, l'In(66,3)Bi(33,7) qui présente un point de fusion de 72 °C, le Bi(57)In(26)Sn(17) qui présente un point de fusion de 79 °C, le Bi(54)In(29,7)Sn(16,3) qui présente un point de fusion de 81 °C, l'In(52,2)Sn(46)Zn(1,8) qui présente un point de fusion de 108 °C, le Bi(67)In(33) qui présente un point de fusion de 109 °C et l'In(52)Sn(48) qui présente un point de fusion de 118 °C.

9. Assemblage d'éclairage selon la revendication 1, dans lequel le câble de connecteur (122) est flexible.

10. Assemblage d'éclairage selon la revendication 1, comprenant en outre une feuille de barrière avant qui est disposée selon une relation sensiblement parallèle par rapport à la source de lumière (102) de sorte qu'elle soit adjacente à celle-ci et qui est collée de façon étanche sur la feuille arrière (110), d'où ainsi l'encapsulation hermétique de la source de lumière (102) à l'intérieur de l'assemblage d'éclairage (100).

11. Procédé d'établissement d'une voie pour une connexion électrique dans un assemblage d'éclairage (100), comprenant :
la fourniture d'une source de lumière sensiblement plane (102) qui comporte une surface d'émission de lumière, une feuille arrière (110) qui s'étend selon une relation sensiblement parallèle par rapport à celle-ci et au moins une région d'alimentation électrique traversante (120) dans la feuille arrière (110), chaque région d'alimentation électrique traversante (120) étant sensiblement recouverte par un patch de contact qui est disposé selon une relation sensiblement plane entre la source de lumière et la feuille arrière, dans lequel la source de lumière (102) est une OLED qui comprend une couche de cathode, une couche d'anode et une couche organique entre les couches de cathode et d'anode ;
la fourniture d'un câble de connecteur (122) qui comporte une première partie pour une connexion sur la source de lumière (102) et une seconde partie pour une connexion avec un circuit de commande associé, dans lequel la première partie comprend au moins un plot de connexion pour établir une connexion électrique avec la source de lumière ;
le positionnement de l'au moins un plot de connexion du câble de connecteur (122) au-dessus du patch au niveau de l'au moins une région d'alimentation électrique traversante (120) de la feuille arrière (110) ; et
le fait de faire fluer un matériau de soudure basse température (160) entre l'au moins un plot de connexion et le patch de manière à établir une voie pour connecter électriquement la source de lumière (102) et le circuit de commande associé, dans lequel un ou plusieurs élément(s) constitutif(s) pris parmi la source de lumière plane, le câble de connecteur, la feuille arrière ou une quelconque partie afférente est/sont construit(s) à partir d'une ou de plusieurs matière(s) plastique(s).

12. Procédé selon la revendication 11, dans lequel l'assemblage d'éclairage (100) est complètement stratifié, et la voie pour connecter électriquement la source de lumière (102) et le circuit de commande associé est formée ensuite lors d'une étape de post-stratification en faisant fluer la soudure entre l'au moins un plot de connexion sur le câble de connecteur et le patch de contact sur la feuille arrière (110).

13. Procédé selon la revendication 11, dans lequel l'assemblage d'éclairage (100) est assemblé, y compris la fourniture du matériau de soudure basse température (160) entre le plot de connexion et le patch de contact, et pendant une autre étape de processus de stratification pour encapsulation hermétique, la soudure est soumise à fluage de manière à former la voie pour la connexion électrique de la source de lumière (102) et du circuit de commande associé.

14. Procédé selon la revendication 11, dans lequel la feuille arrière (110) est préassemblée, y compris le fait de faire fluer le matériau de soudure basse température (160) entre le plot de connexion et le patch de contact, ce fluage étant suivi par l'assemblage et la stratification de la feuille arrière préassemblée (110) avec les parties restantes de l'assemblage d'éclairage.
